Europäisches Patentamt

European Patent Office

Office européen des brevets

(11) Veröffentlichungsnummer: **0 302 172**
**A1**

## (12) EUROPÄISCHE PATENTANMELDUNG

(21) Anmeldenummer: 88104425.9

(51) Int. Cl.⁴: **G01R 21/08**

(22) Anmeldetag: 19.03.88

(30) Priorität: 06.08.87 CH 3028/87

(43) Veröffentlichungstag der Anmeldung:
08.02.89 Patentblatt 89/06

(84) Benannte Vertragsstaaten:
AT BE CH DE ES FR GB IT LI NL SE

(71) Anmelder: LGZ LANDIS & GYR ZUG AG

CH-6301 Zug(CH)

(72) Erfinder: Halder, Mathis
Burgmatt 28b
CH-6340 Baar(CH)
Erfinder: Der weitere Erfinder hat auf seine
Nennung verzichtet

(54) Anordnung zur Ermittlung einer Summe elektrischer Leistungen, insbesondere zur Verwendung in Mehrphasen-Elektrizitätszählern.

(57) Die Anordnung enthält mehrere Multiplizierschaltungen (27, 28, 29), die je ein Hallelement (22) enthalten und deren Ausgänge elektrisch in Reihe geschaltet sind. Pro Hallelement (22) ist ein mit einem zweipoligen Eingang versehener Verstärker (24) vorhanden. Der Ausgang eines jeden Hallelementes (22) und der zweipolige Eingang eines jeden zugehörigen Verstärkers (24) sind elektrisch in Reihe geschaltet. Pro Verstärker (24) ist je ein zweipoliger, als Polaritätsumschalter arbeitender Umschalter (21) vorhanden. Der Ausgang eines jeden Verstärkers (24) ist über einen ersten Umschaltkontakt (21b) des zugehörigen Umschalters (21) mit einem Pol des Speisestromeingangs des Hallelementes (22) verbunden, während der Ausgang des Spannungs/Strom-Wandlers (23) über einen zweiten Umschaltkontakt (21a) des Umschalters (21) mit dem andern Pol des Speisestromeingangs des Hallelementes (22) verbunden ist.

Fig. 3

## Anordnung zur Ermittlung einer Summe elektrischer Leistungen, insbesondere zur Verwendung in Mehrphasen-Elektrizitätszählern

Die Erfindung bezieht sich auf eine Anordnung zur Ermittlung einer Summe elektrischer Leistungen, insbesondere zur Verwendung in Mehrphasen-Elektrizitätszählern, gemäss dem Oberbegriff des Anspruchs 1.

Derartige Anordnungen werden z. B. in Mehrphasenzählern zur Messung der Summe elektrischer Leistungen aller Phasen oder in Summenzählern zur Messung der Summe beliebiger Leistungen verwendet. Die Leistungen können dabei Wirk-, Blind- oder Scheinleistungen sein. In Elektrizitätszählern wird diese Summe anschliessend über eine Zeit integriert um den zugehörigen Energiewert zu ergeben, der dann angezeigt wird.

Eine Anordnung der eingangs genannten Art ist aus der CH-PS 483 021 bekannt. In dieser Anordnung sind Hallelemente mit Widerständen und ihre Summenausgangsspannung mit einem relativ niederohmigen Tiefpassfilter belastet. Der Gleichspannungsanteil dieser Summenausgangsspannung benötigt zur Verbesserung der Genauigkeit der Anordnung einen relativ kompliziert aufgebauten Verstärker mit einer phasenempfindlichen Steuerung eines Gleichrichters.

Der Erfindung liegt die Aufgabe zugrunde, eine Anordnung der eingangs genannten Art zu schaffen, deren Hallelemente nicht mit Widerständen belastet sind, die kein Tiefpassfilter aufweist und keinen kompliziert aufgebauten Verstärker benötigt.

Die genannte Aufgabe wird erfindungsgemäss durch die im Kennzeichen des Anspruchs 1 angegebenen Merkmale gelöst.

Ausführungsbeispiele der Erfindung sind in der Zeichnung dargestellt und werden im folgenden näher beschrieben.

Es zeigen:

Fig. 1 ein vereinfachtes Blockschaltbild eines Elektrizitätszählers, der der Messung einer Summe von drei Energien dient,

Fig. 2 ein Blockschaltbild einer ersten Variante einer Eingangsschaltung des in der Fig. 1 dargestellten Elektrizitätszählers und

Fig. 3 ein Blockschaltbild einer zweiten Variante einer Eingangsschaltung des in der Fig. 1 dargestellten Elektrizitätszählers.

Gleiche Bezugszahlen bezeichnen in allen Figuren der Zeichnung gleiche Teile.

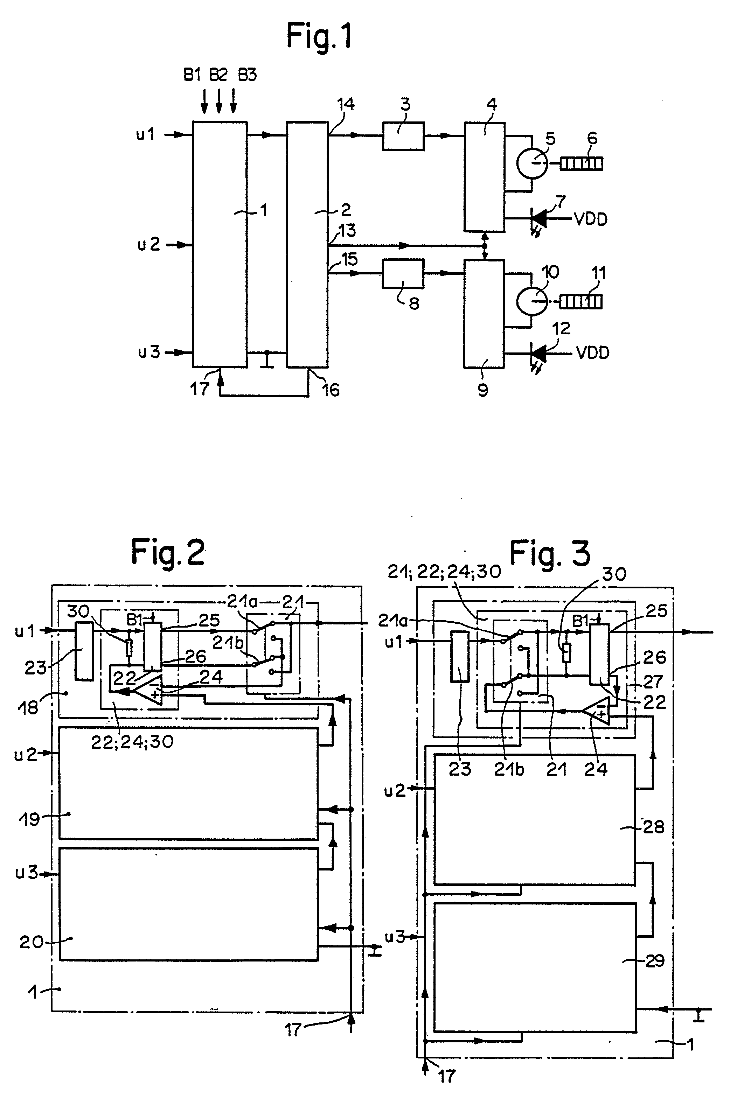

Der in der Fig. 1 dargestellte Elektrizitätszähler besitzt einen an sich bekannten prinzipiellen Aufbau und besteht aus einer Eingangsschaltung 1, einem Spannungs/Frequenz-Wandler 2, einem nur fakultativ vorhandenen ersten Frequenzteiler 3, einer ersten Interfaceschaltung 4, einem ersten Schrittmotor 5, einer ersten Anzeige 6, einer ersten Leuchtdiode 7, einem nur fakultativ vorhandenen zweiten Frequenzteiler 8, einer zweiten Interfaceschaltung 9, einem zweiten Schrittmotor 10, einer zweiten Anzeige 11 und einer zweiten Leuchtdiode 12. Dieser Elektrizitätszähler dient z. B. der Messung einer Dreiphasen-Energie, also der Messung der Summe von drei Energien, die jede durch eine Spannung uk und einen Strom ik gekennzeichnet ist, mit k = I, 2 oder 3. Die Ströme ik werden auf an sich bekannte und daher nicht dargestellte Weise in je eine proportionale Induktion Bk des von ihnen jeweils erzeugten Magnetfeldes umgewandelt. Die Eingangsschaltung 1 ist somit dem Einfluss der drei Induktionen B1, B2 und B3 ausgesetzt und besitzt als Eingangsspannungen die drei Spannungen u1, u2 und u3. Der Ausgang der Eingangsschaltung 1 ist zweipolig mit dem Eingang des Spannungs/Frequenz-Wandlers 2 verbunden, wobei ein Pol an Masse liegt. Der Spannungs/Frequenz-Wandler 2 besitzt einen ersten Taktausgang 13, einen Datenausgang 14 für positive Energie, einen Datenausgang 15 für negative Energie und einen zweiten Taktausgang 16. Der Datenausgang 14 bzw. 15 des Spannungs/Frequenz-Wandlers 2 ist mit dem Eingang der Bauelementegruppe 3; 4; 5; 6; 7 bzw. 8; 9; 10; 11; 12 verbunden, die der Messung und Anzeige der positiven bzw. negativen Energie dient. Jede dieser beiden Bauelementegruppen ist genau identisch aufgebaut. Der Datenausgang 14 bzw. 15 des Spannungs/Frequenz-Wandlers 2 ist, falls vorhanden, über den Frequenzteiler 3 bzw. 8, sonst direkt, auf einen Dateneingang der Interfaceschaltung 4 bzw. 9 geführt. Der erste Taktausgang 13 des Spannungs/Frequenz-Wandlers 2 ist mit je einem Takteingang der Interfaceschaltungen 4 und 9 verbunden, während sein zweiter Taktausgang 16 direkt auf einen Takteingang der Eingangsschaltung 1 geführt ist. Je ein zweipoliger Ausgang der Interfaceschaltungen 4 und 9 speist einen Schrittmotor 5 bzw. 10, der je eine Anzeige 6 bzw. 11 mechanisch betätigt. Anstelle der Bauelementegruppen 5; 6 und 10; 11 kann auch eine rein elektronische Bauelementegruppe verwendet werden, die z. B. aus der Kaskadenschaltung eines Binärzählers und einer 7-Segment-Anzeige aus Leuchtdioden oder Flüssigkristallen besteht. Die Binärzähler sind dann vorzugsweise mit nichtflüchtigen Speichern aufgebaut, damit ihr Informationsinhalt bei Spannungsausfall nicht verloren geht. Ein einpoliger zeitserieller Ausgang der Interfaceschaltungen 4 und 9 speist z. B. die Kathode der Leuchtdiode 7 bzw. 12, deren Anode jeweils am positiven Pol VDD einer Speisegleichspannung liegt. In der Eingangsschaltung 1 werden die Produkte u1.B1, u2.B2 und u3.B3, die die jeweiligen Einphasen-Leistungen darstellen, gebildet und miteinander addiert, wobei der Summenwert periodisch umgepolt wird, so dass am Ausgang der Eingangsschaltung 1 eine elektrische Spannung erscheint, die proportional diesem periodisch umgepolten Summenwert ist. Die periodische Umpolung wird im Spannungs/Frequenz-Wandler 2 wieder rückgängig gemacht durch eine synchrone zweite Umpolung. Beide Umpolungen dienen dazu, Fehlersignale wie "Offset"- Spannungen oder sonstige Gleichspannungs-Störsignale, die die Messgenauigkeit beeinträchtigen und die nur einmal, statt zweimal umgepolt werden, zu eliminieren. Die synchrone doppelte Umpolung geschieht mit Hilfe eines im Spannungs/Frequenz-Wandler 2 erzeugten Taktsignals, welches über den zweiten Taktausgang 16 des Spannungs/Frequenz-Wandlers 2 den Takteingang 17 der Eingangsschaltung 1 speist. Ausserdem wandelt der Spannungs/Frequenz-Wandler 2 die Ausgangsspannung der Eingangsschaltung 1 um in eine Impulsfolge rechteckförmiger Impulse, deren Frequenz proportional der Ausgangsspannung der Eingangsschaltung 1 ist. Der Aufbau des Spannungs/Frequenz-Wandlers 1 ist z. B. beschrieben in der EP-Anmeldung Nr. 86108493.7 und in der US-Anmeldung 06/904.045.

Die Impulsfrequenz am Datenausgang 14 bzw. 15 des Spannungs/Frequenz-Wandlers 2 ist somit proportional der positiven bzw. negativen Summe der elektrischen Leistungen und wird ggf. fakultativ noch im Frequenzteiler 3 bzw. 8 durch eine Konstante geteilt. Die Impulsfolge wird anschliessend durch die Interfaceschaltung 4 bzw. 9 auf an sich bekannte Weise sowohl spannungsmässig als auch strommässig an die Bedürfnisse des Schrittmotors 5 bzw. 10 angepasst, der die Impulse zählt, dadurch die Summe der Leistungen über die Zeit integriert und sie somit in die Summe der Energien umwandelt. Diese Summenenergie wird durch die Anzeigen 6 (positive Energie) und/oder 11 (negative Energie) angezeigt. Ausserdem erlaubt die Anwesenheit der Leuchtdioden 7 und 12 (eine für die positive und eine für die negative Summe der Leistungen), die im Rhythmus der Impulsfrequenzen blinken, die Impulsfrequenzen, die wie bereits erwähnt proportional der Summe der Leistungen sind, mittels einer externen optischen Einrichtung zu messen und dort z. B. mittels einer Integration auszuwerten.

Es ist offensichtlich, dass, wenn nur eine Art positive oder negative Energie vorhanden ist und gemessen werden muss, eine der beiden Baugruppen 3; 4; 5; 6; 7 oder 8; 9; 10; 11; 12 überflüssig ist und weggelassen werden kann.

Das Blockschaltbild der Fig. 2 stellt eine erste Variante der Eingangsschaltung 1 dar und besteht z. B. aus drei Multiplizierschaltungen 18, 19 und 20, die alle drei identisch aufgebaut sind. Die erste Multiplizierschaltung 18 besitzt als Eingangssignal die Spannung u1 und ist der Induktion B1 ausgesetzt. Die zweite Multiplizierschaltung 19 besitzt als Eingangssignal die Spannung u2 und ist nicht dargestellt der Induktion B2 ausgesetzt. Die dritte Multiplizierschaltung 20 besitzt als Eingangssignal die Spannung u3 und ist nicht dargestellt der Induktion B3 ausgesetzt.

· Die Ausgänge der drei Multiplizierschaltungen 18 bis 20 sind elektrisch in Reihe geschaltet, wobei die zwei Pole dieser Reihenschaltung den Ausgang der Eingangsschaltung 1 und damit den Ausgang der erfindungsgemässen Anordnung bilden.

Der innere Aufbau der drei identischen Multiplizierschaltungen 18 bis 20 ist in der Fig. 2 nur für die Multiplizierschaltung 18 dargestellt und besteht jeweils aus einem zweipoligen, als Polaritätsumschalter arbeitenden Umschalter 21, einem Hallelement 22, einem Spannungs/Strom-Wandler 23, einem Verstärker 24 und einem nur fakultativ vorhandenen temperaturabhängigen Widerstand 30. Pro Hallelement 22 ist somit ein Verstärker 24 und pro Verstärker 24 ein Umschalter 21 vorhanden. Der Verstärker 24 ist jeweils mit einem zweipoligen Eingang versehen, nämlich mit einem invertierenden und einem nichtinvertierenden Eingang. Er besteht z. B. aus einem Operationsverstärker.

Der Umschalter 21 besitzt zwei Umschaltkontakte 21a und 21b, die z. B. mechanisch miteinander gekoppelt sind. Innerhalb des Umschalters 21 ist der erste Pol von dessen Eingang über den Oeffnungskontakt des einen Umschaltkontaktes 21a mit dem ersten Pol und über den Schliesskontakt dieses Umschaltkontaktes 21a mit dem zweiten Pol jeweils des Ausgangs des Umschalters 21 verbunden. Aehnlich ist innerhalb des Umschalters 21 der zweite Pol des Eingangs des Umschalters 21 über den Schliesskontakt des andern Umschaltkontaktes 21b des Umschalters 21 mit dem ersten Pol und über den Oeffnungskontakt dieses Umschaltkontaktes 21b mit dem zweiten Pol des Ausgangs des Umschalters 21 verbunden. Der Takteingang 17 der Eingangsschaltung 1 ist mit dem Steuereingang aller drei Umschalter 21 verbunden.

Das Hallelement 22 ist der Induktion Bk ausgesetzt. Der Eingang des Spannungs/Strom-Wandlers 23 ist von der Spannung uk gespeist. Dabei gilt jeweils k = 1 für die Multiplizierschaltung 18, k = 2 für die Multiplizierschaltung 19 und k = 3 für die Multiplizierschaltung 20. Der Ausgang des Spannungs/Strom-Wandlers 23 ist mit einem Pol des Speisestromeingangs des Hallelementes 22 und damit mit einem Pol des Eingangs der Hallelementeschaltung 22; 24; 30 verbunden. Der Ausgang 25; 26 des Hallelementes 22 ist mit dem Eingang des zugehörigen Umschalters 21 verbunden. Ein erster Ausgangspol des Umschalters 21 bildet einen ersten Ausgangspol der Multiplizierschaltung 18, 19 bzw. 20 und der zweite Ausgangspol des Umschalters 21 ist auf einen invertierenden Eingang des Verstärkers 24 geführt, dessen nichtinvertierender Eingang einen zweiten Ausgangspol der Multiplizerschaltung 18, 19 bzw. 20 bildet. Der zweipolige Ausgang des Hallelementes 22 ist somit über einen Umschaltkontakt 21a bzw. 21b des zugehörigen Umschalters 21 mit dem zweipoligen Eingang des zugehörigen Verstärkers 24 jeweils elektrisch in Reihe geschaltet. Die beiden Pole dieser Reihenschaltung sind jeweils über den andern Umschaltkontakt 21b bzw. 21a des zugehörigen Umschalters 21 auf den Ausgang der zugehörigen Multiplizierschaltung 18, 19 oder 20 geführt. Der Ausgang des Verstärkers 24 ist jeweils mit dem andern Pol des Speisestromeingangs des Hallelementes 22 und damit mit einem Pol eines Eingangs der zugehörigen Hallelementeschaltung 22; 24; 30 verbunden.

Die Spannung uk wird im Spannungs/Strom-Wandler 23 jeweils in einen proportionalen Strom umgewandelt, der das Hallelement 22 speist. Das Hallelement 22 bildet das Produkt dieses Stromes und der Induktion Bk, so dass seine Ausgangsspannung proportional uk.Bk und damit proportional der Leistung uk.ik ist. Durch die Reihenschaltung der Ausgänge der Multiplizierschaltungen 18, 19 und 20 entsteht die Summe der Leistungen, nämlich $(+/-)u1.i1 + (+/-)u2.i2 + (+/-)u3.i3$. Dabei arbeiten alle Verstärker 24 jeweils als Regelverstärker, wobei der Istwert eines jeden Regelkreises je nach Stellung des Umschalters 21 jeweils das Spannungspotential eines der beiden Ausgangspole 26 bzw. 25 des Hallelementes 22 ist. Der am nichtinvertierenden Eingang des Verstärkers 24 jeweils anstehende Sollwert eines jeden Regelkreises ist das Spannungspotential des andern Ausgangspols 25 bzw. 26 des in der Reihenschaltung nachfolgenden Hallelementes 22, wobei der Sollwert des ersten Regelkreises die Masse ist. Am Ausgang eines jeden Verstärkers 24 ist dann eine Spannung vorhanden, die proportional der Sollwert/Istwert-Differenz des jeweiligen Regelkreises ist und die über das Hallelement 22 dem Spannungspotential am Ausgangspol 26 bzw. 25 des Hallelementes 22 derartig entgegenwirkt, dass die Sollwert/Istwert-Differenz annähernd gleich null wird. Wenn dies der Fall ist, dann ist das Spannungspotential des Ausgangspols 26 bzw. 25 annähernd gleich dem Sollwert. Am Takteingang 17 der Eingangsschaltung 1 steht ein periodisches rechteckförmiges Signal an, welches die zweipoligen Umschalter 21 synchron und periodisch umschaltet. Da der Umschalter 21 als Polaritätsumschalter verdrahtet ist, wird durch seine periodische Umschaltung periodisch die Polarität der an der Reihenschaltung der Ausgänge der Multiplizierschaltungen 18, 19 und 20 anstehenden Spannung umgepolt.

Das Blockschaltbild der Fig. 3 stellt eine zweite Variante der Eingangsschaltung 1 dar und besteht aus drei Multiplizierschaltungen 27, 28 und 29, die wiederum alle drei identisch aufgebaut sind. Die erste Multiplizierschaltung 27 besitzt als Eingangssignal die Spannung u1 und ist der Induktion B1 ausgesetzt. Die zweite Multiplizierschaltung 28 besitzt als Eingangssignal die Spannung u2 und ist nicht dargestellt der Induktion B2 ausgesetzt. Die dritte Multiplizierschaltung 29 besitzt als Eingangssignal die Spannung u3 und ist nicht dargestellt der Induktion B3 ausgesetzt.

Die Ausgänge der drei Multiplizierschaltungen 27 bis 29 sind elektrisch wiederum in Reihe geschaltet, wobei die zwei Pole dieser Reihenschaltung den Ausgang der Eingangsschaltung 1 und damit den Ausgang der erfindungsgemässen Anordnung bilden. Der Takteingang 17 der Eingangsschaltung 1 ist mit je einem Steuereingang der Multiplizierschaltungen 27, 28 und 29 verbunden.

Der Aufbau der drei identischen Multiplizierschaltungen 27 bis 29 ist in der Fig. 3 nur für die Multiplizierschaltung 27 dargestellt und besteht aus einem Hallelement 22, einem Spannungs/Strom-Wandler 23, einem zweipoligen Umschalter 21, einem Verstärker 24 und einem nur fakultativ vorhandenen temperaturabhängigen Widerstand 30. Pro Hallelement 22 ist somit auch hier ein Verstärker 24 vorhanden. Die Multiplizierschaltungen 27 bis 29 gemäss der Fig. 3 sind ähnlich aufgebaut wie die Multiplizierschaltungen 18 bis 20 der Fig. 2 mit dem Unterschied, dass der Ausgang des Spannungs/Strom-Wandlers 23 und des Verstärkers 24 nicht direkt, sondern jeweils über den zweipoligen Umschalter 21 mit dem zweipoligen Speisestromeingang des Hallelementes 22 verbunden ist und dass die Reihenschaltung des Ausgangs des Hallelementes 22 und des zweipoligen Eingangs des zugehörigen Verstärkers 24 direkt, ohne Zwischenschaltung des Umschalters 21 erfolgt. Pro Hallelement 22 und damit auch pro Verstärker 24 ist somit je ein zweipoliger, als Polaritätsumschalter arbeitender Umschalter 21 vorhanden. Der Ausgang des Verstärkers 24 ist über einen Umschaltkontakt 21b des zugehörigen Umschalters 21 mit einem Pol des Speisestromeingangs des zugehörigen Hallelementes 22 und damit direkt mit einem Pol des Eingangs der zugehörigen Hallelementeschaltung 21; 22; 24; 30 verbunden, während der nicht direkt mit dem Ausgang des Verstärkers 24 verbundene Pol des Eingangs der Hallelementeschaltung 21; 22; 24; 30 über den andern Umschaltkontakt 21a des zugehörigen Umschalters 21 mit dem andern Pol des Speisestromeingangs des zugehörigen Hallelementes 22 verbunden ist. Der Steuereingang des Umschalters 21
bildet dabei jeweils den Steuereingang der
Multiplizierschaltung 27, 28 bzw. 29. Der Umschalter 21 der Fig. 3 ist genauso aufgebaut und
genauso verdrahtet wie der Umschalter 21 der Fig.
2.

Die Schaltung gemäss der Fig. 3 arbeitet ähnlich wie die Schaltung der Fig. 2, insbesondere
arbeiten auch hier die Verstärker 24 als Regelverstärker genauso wie in der Schaltung der Fig. 2.

Da das von dem Spannungs/Strom-Wandler 23
gelieferte Nutzsignal vor Erreichen des Hallelementes 22 durch den Umschalter 21 umgepolt wird,
hat diese Umpolung keinen Einfluss auf die Polarität des im Hallelement 22 intern erzeugten Störanteils der Ausgangsspannung des Hallelementes
22. Die Polarität dieses Störanteils ist somit unabhängig von der z. B. periodischen Polaritätsumschaltung des Nutzsignals und kann dadurch später relativ einfach im nachgeschalteten
Spannungs/Frequenz-Wandler 2 auf an sich bekannte Weise eliminiert werden.

In den Figuren 2 und 3 ist dem zweipoligen
Speisestromeingang des Hallelementes 22 noch
jeweils ein temperaturabhängiger Widerstand 30
parallelgeschaltet, der nur fakultativ vorhanden ist.
Er dient der Temperaturkompensation.

Der Umschalter 21 wurde in den Figuren als
elektromechanischer Schalter dargestellt. In der
Praxis ist er vorzugsweise ein Halbleiterschalter.
Der Spannungs/Strom-Wandler 23 besteht jeweils
vorzugsweise aus einem Widerstand.

## Ansprüche

1. Anordnung zur Ermittlung einer Summe
elektrischer Leistungen, insbesondere zur Verwendung in Mehrphasen-Elektrizitätszählern, mit mindestens einem Verstärker (24), mindestens einem
Umschalter (21) und mehreren Multiplizierschaltungen (18, 19, 20 bzw. 27, 28, 29), die ein
Hallelement (22) enthalten und deren Ausgänge
elektrisch in Reihe geschaltet sind, wobei die zwei
Pole dieser Reihenschaltung den Ausgang der Anordnung bilden, dadurch gekennzeichnet, dass pro
Hallelement (22) ein mit einem zweipoligen
Eingang versehener Verstärker (24) vorhanden ist,
die beide Teil einer Hallelementeschaltung (22; 24;
30 bzw. 21; 22; 24; 30) sind, dass pro Verstärker
(24) je ein zweipoliger, als Polaritätsumschalter arbeitender Umschalter (21) vorhanden ist, dass der
Ausgang eines jeden Hallelementes (22) und der
zweipolige Eingang eines jeden zugehörigen Verstärkers (24) elektrisch in Reihe geschaltet sind und dass die beiden Pole dieser weiteren Reihenschaltung jeweils auf den Ausgang der zugehörigen Multiplizierschaltung (18, 19, 20 bzw. 27, 28,
29) geführt sind, wobei der Ausgang der Verstärker
(24) jeweils mit einem Pol eines Eingangs der
Hallelementeschaltung (22; 24; 30 bzw. 21; 22; 24;
30) verbunden ist.

2. Anordnung nach Anspruch 1, dadurch gekennzeichnet, dass der Ausgang eines jeden Hallelementes (22) über einen Umschaltkontakt (21a
bzw. 21b) des zugehörigen Umschalters (21) mit
dem zweipoligen Eingang des zugehörigen Verstärkers (24) elektrisch in Reihe geschaltet ist und
dass die beiden Pole dieser Reihenschaltung
jeweils über den andern Umschaltkontakt (21b bzw.
21a) des zugehörigen Umschalters (21) auf den
Ausgang der zugehörigen Multiplizierschaltung (18,
19, 20) geführt sind.

3. Anordnung nach Anspruch 1, dadurch gekennzeichnet, dass der Ausgang eines jeden Verstärkers (24) über einen ersten Umschaltkontakt
(21b) des zugehörigen Umschalters (21) mit einem
Pol des Speisestromeingangs des Hallelementes
(22) verbunden ist, während ein nicht direkt mit
dem Ausgang des Verstärkers (24) verbundener
Pol des Eingangs der Hallelementeschaltung (21;
22; 24; 30) über einen zweiten Umschaltkontakt
(21a) des Umschalters (21) mit dem andern Pol
des Speisestromeingangs des Hallelementes (22)
verbunden ist.

EP 0 302 172 A1

Fig. 1

Fig. 2

Fig. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE-A-2 951 627  (ZÄHLER)<br>* Seiten 1,2 *<br>--- | 1 | G 01 R  21/08 |
| A | PATENT ABSTRACTS OF JAPAN, Band 7, Nr. 105 (P-195)[1250], 7. Mai 1983; & JP-A-58 28 665 (MITSUBISHI DENKI K.K.) 19-02-1983<br>--- | | |
| A | US-A-3 955 138  (GENERAL ELECTRIC)<br>--- | | |
| A | US-A-3 875 508  (GENERAL ELECTRIC)<br>--- | | |
| A | EP-A-0 134 001  (SIEMENS)<br>----- | | |

| | RECHERCHIERTE SACHGEBIETE (Int. Cl.4) |
|---|---|
| | G 01 R |

Der vorliegende Recherchenbericht wurde für alle Patentansprüche erstellt

| Recherchenort | Abschlußdatum der Recherche | Prüfer |
|---|---|---|
| DEN HAAG | 11-08-1988 | HOORNAERT W. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes
    Dokument

EPO FORM 1503 03.82 (P0403)